# EUROPEAN PATENT APPLICATION

(11) **EP 1 324 377 A2**
(43) Date of publication of application: **02.07.2003**
(21) Application number: 02102881.6
(22) Date of filing: 23.12.2002
(51) Int. Cl.: H01L 21/265

(54) **Method of forming shallow abrupt junctions in semiconductor devices**

(30) Priority: 28.12.2001 US 344516 P; 24.07.2002 US 205380
(71) Applicant: Texas Instruments Incorporated, Dallas, Texas 75251 (US)
(72) Inventor: Robertson, Lance Stanford, Rockwell, TX 75087 (US)
(74) Representative: Holt, Michael

(57) **Abstract**

Disclosed are apparatus and methods for forming abrupt junctions in semiconductor devices. Initially, a substrate (200) is implanted with an amorphizing element (208) in a desired area (300), rendering the melting point of the desired area lower than the melting point of the substrate surrounding the desired area. A desired dopant (302) is implanted into the desired area, and the desired area is then annealed by an energy source (402, 506) such that only the desired area melts, allowing the dopant to diffuse throughout only the desired area.

## Description

### FIELD OF THE INVENTION

The present invention relates in general to fabrication and operation of semiconductor devices and, more particularly, to apparatus and methods for forming ultra shallow device features during the fabrication of a semiconductor device.

### BACKGROUND OF THE INVENTION

The continual demand for enhanced integrated circuit performance has resulted in, among other things, a dramatic reduction of semiconductor device geometries, and continual efforts to optimize the performance of every substructure within any semiconductor device. A number of improvements and innovations in fabrication processes, material composition, and layout of the active circuit levels of a semiconductor device have resulted in very high-density circuit designs. Increasingly dense circuit design has not only improved a number of performance characteristics, it has also increased the importance of, and attention to, semiconductor material properties and behaviors.

As semiconductor device geometries are continually scaled downward, critical structures and features within semiconductor devices must also scale downward. Problems arise, however, when certain device structures or features become too shallow. Consider, for example, the formation of junctions in extremely shallow device geometries. Junctions between device layers, or between areas of differing material composition, may be thought of as the most basic element of semiconductor device architecture. Typically, when the depth of a shallow junction formed by conventional methods decreases, the sheet resistance of that structure increases. That increased resistance presents a number of performance problems.

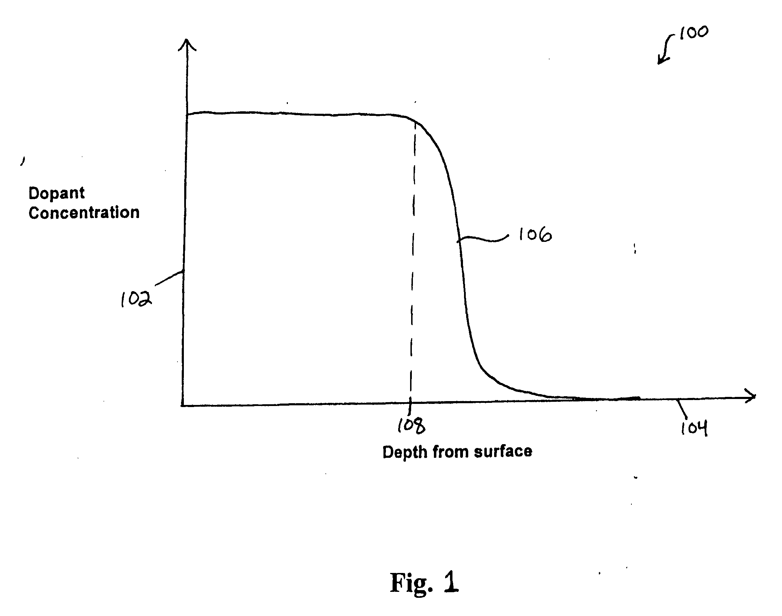

In response to this, the formation of abrupt junctions has been attempted. An abrupt junction is generally defined by a very sharp transition from a highly doped region in a semiconductor structure to an adjoining region with little or no doping. This concept is illustrated in graph 100 of Figure 1. Graph 100 plots the dopant concentration 102 for a given region in a semiconductor device as a function of distance 104 from the surface through which the dopant was implanted. Plot line 106 illustrates that, up to a given depth 108, a high concentration of dopant is maintained. Past depth 108, the given region has a very sudden transition to little or no dopant - thus forming an abrupt junction between the areas of high doping and no doping. A more gradual transition would indicate greater diffusion of the dopant into the material past depth 108, changing the electrical characteristics and performance of that region. Abrupt junctions are thus desirable for the formation of shallow device features, in order to provide desired electrical performance.

There are a number of conventional methodologies that have been employed to overcome the limitations imposed on forming abrupt junctions by material physical properties. A variety of epitaxial and annealing techniques have been adapted in efforts to produce abrupt junction structures. Nonetheless, considering the fabrication technologies employed and the required performance characteristics of the device structures being formed, even such adapted conventional techniques are approaching the limit of their ability to produce shallow structures. Past that limit, material diffusivity and other material property phenomena can cause certain device characteristics to change dramatically and detrimentally (e.g., a large increase in the leakage current) - if fabrication past that limit is even possible at all. Thus, device designers are left with a trade-off between achieving desired device geometries and accepting certain device or performance degradations.

As noted, conventional techniques used to form shallow junction structures include various epitaxy methods, rapid thermal annealing (RTA), and laser annealing. In general, epitaxial methods involve the deposition of a thin layer of material onto the surface of a single crystal substrate, in such a manner that the layer has the same crystallographic orientation as the original substrate and becomes an extension of the substrate. During the deposition, conventional n and p type impurities can be incorporated into the layer. Control of the impurity concentration, as well as layer thickness, to necessary tolerances makes epitaxy one of the most challenging techniques in semiconductor manufacturing. There are, of course, a number of disadvantages to epitaxial methods. Complicated etch processes involved in epitaxy present a number of process integration problems, in addition to increased costs and time-to-manufacture problems. Furthermore, depending on the type of epitaxy used, device performance problems (e.g., increased junction leakage current) may occur more readily and frequently.

A number of annealing methods are also conventionally used in forming shallow junction structures. In general, conventional annealing is used to heat an area of a substrate into which a dopant is being implanted - providing enough activation energy to allow migration of a dopant into the crystalline structure of the substrate. With rapid thermal annealing (RTA), a high intensity lamp based system is generally employed to hasten the heating process. This normally includes an array of high intensity lamps (e.g., tungsten-halogen lamps) that are capable of rapid heating. Such processes may, sometimes, also use a spike anneal - a very high-intensity, rapid ramp-up of heat energy. While such spike anneals are considered, by conventional standards, to be very fast, they are still insufficient to produce the shallow, abrupt junctions in smaller geometry devices. The heating and, in some cases, cooling of such methods in very small scale device geometries is typically not fast enough to mitigate or eliminate diffusion of a dopant into surrounding areas. Thus, the result of conventional annealing processes, even RTA, is usually a less-thanabrupt junction.

Laser annealing has been proposed as an alternative to RTA, however, it introduces a number of process integration issues and complexities that render it infeasible for cost-efficient, highvolume semiconductor manufacture. Among conventional methods, only laser annealing appears to be capable of melting a substrate in a highly localized area without melting surrounding crystalline structures - achieving localized metastable solubility in a desired dopant implantation area. Laser annealing thus appears to be capable of yielding higher dopant activation levels, and greater doping abruptness, than other conventional annealing techniques. This is required in order to form the abrupt junctions, as illustrated in Figure 1, required for shallow feature sizes of current and future semiconductor technologies.

Using conventional laser annealing methods, a dopant is implanted within a localized region. The localized region is then exposed to the laser (typically a UV laser), which is used to melt only that localized area. This melting process occurs very quickly, and for a very short amount of time - just long enough to melt the desired localized region. Utilizing such techniques, manufacturers are technically capable of producing an abrupt junction structure.

There are, however, a number of serious fabrication process integration issues stemming from the use of laser annealing. Typical laser annealing processes are not highly controllable, and thus require a number of extra process steps when compared with conventional semiconductor manufacturing. For example, extra masks and layers must be deployed in order to utilize laser annealing (e.g., absorbing layers and reflecting layers). In addition, there are a number of geometric effects of laser annealing that pose serious process integration issues. Laser annealing does not translate easily, or readily, as the area being annealed moves from dense device patterning to sparse device patterning. Laser annealing is not completely uniform. It can yield a number of hot and cool spots within a localized region, and can damage surrounding features in an unintended fashion (e.g., melting polysilicon gates). Even where laser annealing is successful without causing damage, the extra layers and masks involved still have to be etched off, which again increases the number of required process steps.

Another problem with the laser annealing is that in many conventional laser-annealing technologies, only a monochromatic laser is utilized. As such, only a certain wavelength of light is projected upon the substrate undergoing anneal. However, the optical characteristics of various layers and materials in a semiconductor device vary widely. Thus, with the use of a monochromatic laser, a number of layers and features on a substrate may have differing absorbtion characteristics at a particular wavelength of light. Therefore, either multiple lasers must be used, or a polychromatic laser or some other suitable dispersed light source must be developed and deployed. Such a scenario would likely be considered cost-prohibitive and impractical. Thus, while overcoming some limitations of other conventional methods, laser annealing introduces other limitations and concerns.

### SUMMARY OF THE INVENTION

Thus a system that provides metastable activation of a dopant, without limitation by the equilibrium solid solubility of the dopant, is now needed. This system should render effective and efficient abrupt junctions - yielding lower sheet resistance for particular device features and thereby increasing drive current for smaller device geometries. The system should thus provide relief from the tradeoff between minimizing device size and maximizing drive current imposed by conventional methods.

Recognizing this, the present invention provides a system for metastable activation of a dopant without limitation by the equilibrium solid solubility of the dopant, yielding effective and efficient abrupt junctions. The present invention provides for amorphization of a desired doping region, coupled with a flash annealing of the desired region to render a dopant concentration greater than the solid solubility of the dopant.

More specifically, the present invention provides a system for producing semiconductor devices having true abrupt junctions. A localized amorphous region is formed within a substrate. A dopant is then implanted within the localized amorphous region. The localized amorphous region is then annealed such that the dopant diffuses throughout only the localized amorphous region. A singlestage, flash anneal or, in the alternative, a multi-stage anneal may be utilized.

The present invention also provides a system for producing a semiconductor device structure having, within a selected area, a dopant concentration at or near the liquid solubility level of that dopant. The dopant is implanted within a selected area on a substrate that has been pre-amorphized. The selected area is then annealed such that the dopant diffuses throughout only the selected area.

The present invention further provides a system for forming an abrupt junction in a semiconductor device. An amorphizing element is implanted into a localized area below a surface of a substrate, to render the melting point of the localized area lower than the melting point of the substrate material immediately surrounding that area. A desired dopant is then implanted into the localized area. The localized area is then annealed such that only it reaches a metastable state, allowing the dopant to diffuse throughout only the localized area.

### BRIEF DESCRIPTION OF THE DRAWINGS

For a more complete understanding of the present invention, including its features and advantages, reference is made to the following detailed description, taken in conjunction with the accompanying drawings. Corresponding numerals and symbols in the different figures refer to corresponding parts unless otherwise indicated.
Figure 1 depicts a chart illustrating an abrupt junction characteristic;
Figure 2 illustrates pre-amorphization according to the present invention;
Figure 3 illustrates dopant implantation according to the present invention;
Figure 4 illustrates an annealing process according to the present invention; and
Figure 5 illustrates an annealing process according to the present invention.

### DETAILED DESCRIPTION

The present invention defines a system, comprising various structures and methods, for efficiently and effectively forming abrupt junctions, and thereby also provides for effective and efficient formation of semiconductor features in shallow device geometries. The present invention provides flash annealing and amorphization schemes, in an easily scalable system that may be readily adapted and integrated into a number of device fabrication processes. The present invention recognizes that if - during the formation of a feature by implantation of a dopant - a metastable activation level can be provided, then a true low-resistance junction may be formed, decreasing the sheet resistance for the particular device feature. This, in turn, will increase the drive current, making smaller geometry devices more commercially viable.

The present invention changes the energetics and kinetics of the semiconductor processing in order to overcome the depth versus resistance tradeoff encountered in conventional methodologies. Usually, such a tradeoff was imposed by certain physical properties of the materials involved, and by processes encountered during, e.g., dopant activation.

It should be understood that the principles disclosed herein may be applied in a wide range of semiconductor processing applications. For purposes of explanation and illustration, however, the present invention is hereafter described in reference to formation of a simple abrupt junction feature within a shallow geometry substrate.

The present invention provides a preferential melting of a highly doped region (HDR). An HDR is provided by rendering a desired substrate region amorphous prior to implantation of a dopant (i.e., pre-amorphization). The HDR melting of the present invention results in the abrupt, step-function profile of junction depth, as seen in Figure 1. The present invention also provides a rapid solidification of the HDR, providing high dopant activation within the region. The present invention thereby achieves abrupt junction formation efficiently, and provides enhanced device performance, while overcoming many of the complexities and limitations associated with conventional annealing and laser processes.

The amorphization process is used to alter the physical and behavioral characteristics of the substrate (usually silicon). A significant dose of ion implantation, using a material that is isoelectronic in silicon (e.g., germanium), deposits energy into the substrate - changing the lattice structure from a long range ordered structure with covalent bonds to a disordered structure. The amorphous material forms in the substrate, comprising a large concentration of defects within the silicon lattice structure. Amorphization constitutes a phase change, creating a different phase of silicon that is amorphous on the surface of the silicon.

The melting point of amorphous silicon is lower than that of ordered crystalline silicon. This means that the substrate may be heated to a point, between the melting points of the amorphous and non-amorphous silicon, at which only the amorphous silicon melts.

Once the amorphous silicon has melted, the diffusion of dopant is much easier. For example, the diffusion coefficients of many typical dopants (e.g., boron, a common dopant in semiconductor processing) in liquid silicon are orders of magnitude higher than in crystalline silicon. Thus, by heating the substrate such that only the amorphous region melts, a dopant may be implanted in the amorphous region at a concentration level higher than its solid solubility level. If done properly, the silicon surrounding the amorphous region will not have melted, thus limiting diffusion of the dopant into the area surrounding the amorphous region. This unique characteristic enables the formation of abrupt shallow junctions in extremely small process geometries. In such technologies, an ideal junction has a very shallow geometry with a very high conductivity.

Utilizing such a process, however, requires a very rapid cooling of the amorphous region before the dopant has a chance to diffuse into surrounding crystalline silicon. If the crystalline silicon surrounding the amorphous region is heated for too long, the dopant will begin to diffuse into the surrounding silicon. If, however, heating is limited to the surface region of the substrate, the remaining portion of the substrate will act as a heat sink-dissipating the heat absorbed by the amorphous region and cooling it down rapidly. Generally, the thermal conductivity of silicon is very high. Thus, special cooling processes are not required if only the amorphous region is melted.

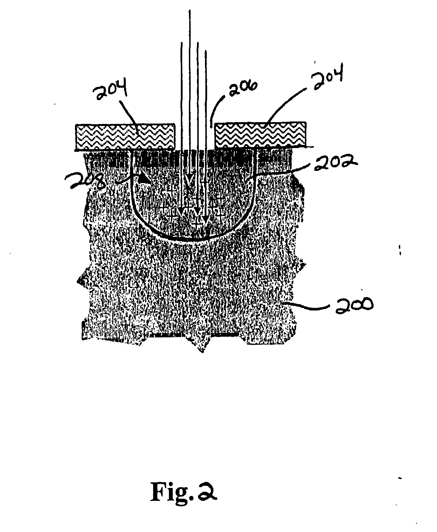

The present invention is now described in greater detail, beginning in reference to Figure 2. A particular substrate 200, within which an abrupt junction structure is desired, is selected for processing. For purposes of explanation and illustration, substrate 200 may comprise a silicon wafer, or some portion thereof. Alternatively, substrate 200 may comprise some other desired semiconductor substrate material. An area 202 is selected within which the desired abrupt junction structure will be formed. Area 202 is then pre-amorphized.

A masking structure 204 is disposed along the surface of substrate 200, leaving open aperture 206 over the desired location of area 202. An element 208 (e.g., molecular or atomic ion) is implanted through aperture 206 to amorphize localized area 202-now the amorphous region.

Element 208 may comprise, for example, silicon or germanium. Alternatively, element 208 may comprise any element or combination of elements from the Periodic Table. Elements other than germanium or silicon, however, may cause certain issues or problems if used as amorphizing elements. As between germanium and silicon, germanium comprises a heavier ion than silicon, and thus requires a lower dose of germanium as an amorphizing element in order to achieve the same amorphization result. Depending upon the particular semiconductor process utilized, however, silicon may be more readily available and thus easier to use in the amorphization process.

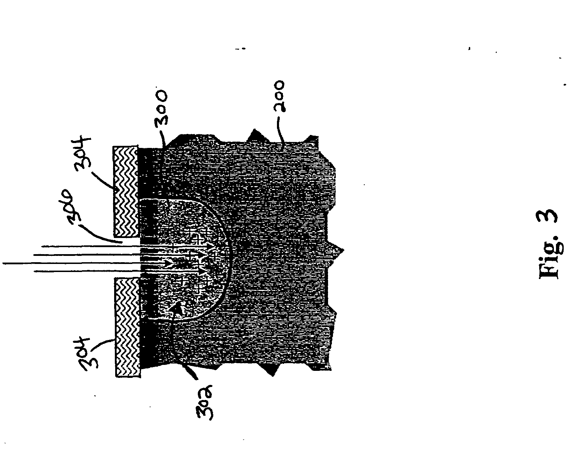

Reference is now made to Figure 3, which depicts substrate 200 with pre-amorphized region 300. A dopant 302 (e.g., boron, arsenic) is selected for implantation in region 300. A masking structure 304 is disposed along the surface of substrate 200, leaving open aperture 306 over the desired implantation area in region 300. Dopant 302 is implanted through aperture 306 into substrate 200.

In order for certain dopants (e.g., boron) to be active, they must occupy substitutional sites within a substrate's lattice structure. The solid solubility of boron, and other similar dopants, in silicon is significantly lower than its liquid solubility in silicon. Thus, if such dopants are present in silicon in a liquid or semi-liquid state (i.e., meta-stable), and cooled very quickly, before diffusion that normally happens during cooling can occur, then the dopants may be quenched onto a substitutional site in the silicon lattice. This results in increased concentration of the dopant - at or near its liquid solubility level - within the desired implant site. For boron and other similar dopants, this increases the conductivity of the implant area and, thus, reduces the resistance of the implant area.

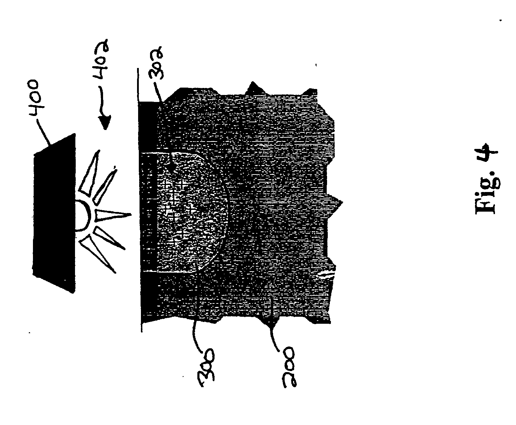

An annealing process is utilized to render a metastable state within region 300, and increase the implanted concentration of dopant 302 therein. In an embodiment of the present invention, illustrated in Figure 4, source 400 provides a highly focused delivery of extremely intense radiative energy 402 (e.g., heat). Energy 402 is directed to melt amorphous region 300 very quickly (e.g., ∼ 1 - 1000 microseconds) - effecting an instantaneous, or "flash", anneal. Importantly, a "flash" anneal of this type is to be distinguished from other, conventional, flash anneals - which are typically less energy intensive and of a duration that is several orders of magnitude longer.

Assuming that substrate 200 comprises silicon, and that region 300 has been amorphized with germanium, energy 402 should heat region 300 to a temperature in the range of approximately 1250°C to 1350°C - such that only region 300 begins to melt. Dopant 302 thus diffuses throughout region 300 and occupies substitutional lattice sites at or near its liquid solubility level. Depending upon the composition of substrate, and the selection of amorphization material, other temperature ranges may be required to render the desired effect. In this embodiment, however, the crystalline silicon surrounding region 300 is not directly heated, and the range to which region 300 is heated is below the melting point of that surrounding silicon. Thus, dopant 302 is not likely to measurably diffuse into the surrounding crystalline silicon, if at all. Furthermore, because of the relatively short duration of delivery of energy 402, once heating of region 300 has ended, the silicon surrounding region 300 acts as a heat sink - quickly dissipating heat from region 300 and rapidly cooling down dopant 302. A high concentration of dopant 302 in region 300 remains, rendering an abrupt junction as previously illustrated in Figure 1.

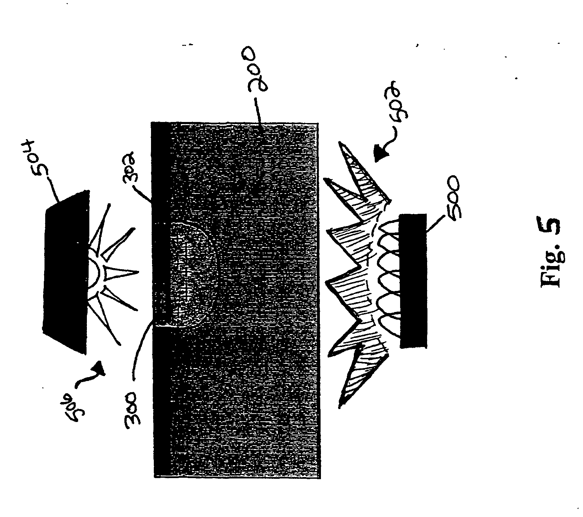

In another embodiment of the present invention, illustrated in Figure 5, substrate 200 is pre-heated to some threshold temperature in order to facilitate the annealing process. This embodiment may be employed in situations where annealing equipment or technology is not capable of the flash anneal described in the previous embodiment. The backside of substrate 200 (or the side farthest from region 300) may be exposed to a radiant energy source 500. Source 500 generates radiative energy 502 (e.g., heat), which is directed to slowly heat substrate 200 to a desired threshold temperature.

A second radiant energy source 504 is positioned over the front side of substrate 200 in proximity to region 300. Source 504 provides a highly focused delivery of extremely intense radiative energy 506 (e.g., heat). Energy 506 is directed to flash heat region 300 from the desired threshold temperature to a desired target temperature, the point at which the amorphous region will become metastable (e.g., ∼ 1250°C - 1350°C for silicon amorphized with germanium). Heating of the backside of substrate 200, up to the desired threshold temperature, should be done at a lower ramp-up rate than the flash anneal previously described. Although the exact value may vary based on the composition of a given substrate, the desired threshold temperature for most silicon substrates will be somewhere around 500°C. Once the entire substrate is heated to a temperature over that, silicon within amorphous region 300 can begin to re-crystallize by solid phase epitaxy - starting from the backside and progressing toward the front side. As temperature increases over 500°C (e.g., once the flash heating begins), the crystalline silicon re-growth rate in region 300 increases steadily. Thus, the desired threshold temperature is sufficiently low so as not to induce significant re-crystallization of the amorphous region. Furthermore, heating from the desired threshold temperature up to the target temperature must be very rapid - rapid enough so as to yield metastable conditions within the amorphous region and allow the implanted dopant to reach solution before the entire area re-crystallizes.

It should be appreciated that the use of a polychromatic or broadband radiant energy source (e.g., a plasma) should alleviate many of the optical loading effects that result from monochromatic heat systems. Using a radiative energy source 504 that can be switched on and off rapidly, having extremely high temperature ramp rates (e.g., ∼ 10⁵-10⁷ °C/sec), melts amorphous region 300 faster than that region can re-crystallize by solid phase epitaxy. A high ramp rate kinetically thus limits the re-growth and forces the amorphous region 300 to melt.

As for potential radiative energy sources, arc lamps may be particularly desirable over other common lamp apparatus (e.g., tungsten lamps) because of the favorable response time of arc lamp technology. Even so, conventional arc lamp annealing systems may require modification to include a high power, ultra fast switching mechanism (e.g., solid state switch, gas-phase switch).

Thus, the present invention provides for beneficial exploitation of difference in melting points between crystalline and amorphous silicon regions. High-precision, high-ramp-rate, high-temperature, annealing provides localized melting without requiring additional absorption or reflection layers and associated integration complexities. The teachings of the present invention can, in most semiconductor production processes, be utilized to effectively and efficiently replace RTA and other conventional annealing processes.

While this invention has been described with reference to illustrative embodiments, this description should not be construed in a limiting sense. Upon reference to the description, it will be apparent to persons skilled in the art that various modifications and combinations of the illustrative embodiments as well as other embodiments of the invention can be made without departing from the spirit and scope of the invention. The structures and methods of the present invention may be employed using a number of different materials in a number of semiconductor fabrication processes. It is therefore intended that the appended claims encompass any such modifications or embodiments.

## Claims

1. A method of producing a semiconductor device having an abrupt junction, comprising the steps of:
providing a substrate having a localized amorphous region;
implanting a desired dopant within the localized amorphous region; and
annealing the localized amorphous region such that the dopant diffuses throughout only the localized amorphous region.

2. The method of claim 1 wherein the step of providing a substrate having a localized amorphous region further comprises implanting an amorphizing element into a localized area below a surface of the substrate to render the melting point of the localized area lower than the melting point of an area immediately surrounding the localized area.

3. The method of claim 1 or claim 2 wherein the step of providing a substrate having a localized amorphous region further comprises providing a substrate comprising silicon.

4. The method of claim 1, claim 2 or claim 3 wherein the amorphizing element comprises germanium.

5. The method of claim 1, claim 2 or claim 3 wherein the amorphizing element comprises silicon.

6. The method of any preceding claim wherein the step of implanting a desired dopant within the localized amorphous region further comprises implanting arsenic.

7. The method of any preceding claim wherein the step of annealing the localized amorphous region such that the dopant diffuses throughout only the localized amorphous region further comprises annealing the localized amorphous region such that only the localized amorphous region reaches a metastable state.

8. The method of claim 7 wherein the step of annealing the localized amorphous region further comprises heating only the localized amorphous region to a temperature sufficient to cause a metastable state in the localized amorphous region within a short time duration.

9. The method of claim 8 wherein the short time duration is in the range of 1 to 1000 microseconds.

10. The method of any preceding claim wherein the step of annealing the localized amorphous region such that the dopant diffuses throughout only the localized amorphous region further comprises:
gradually heating the substrate to a temperature just below the threshold of solid phase epitaxy for the localized amorphous region; and
further heating only the localized amorphous region to a temperature sufficient to cause a metastable state in the localized amorphous region within a short time duration.
